# EUROPEAN PATENT APPLICATION

(11) **EP 3 051 002 A1**
(43) Date of publication of application: **03.08.2016**
(21) Application number: 15156678.3
(22) Date of filing: 26.02.2015
(51) Int. Cl.: C23C 16/455, B05B 17/06, C23C 16/448

(54) **APPARATUS AND METHOD FOR FORMING FILM**

(30) Priority: 29.01.2015 JP 2015015217; 09.02.2015 JP 2015023488
(71) Applicant: Flosfia Inc., Kyoto 615-8245 (JP)
(72) Inventor: Sasaki, Takahiro, Kyoto-shi, Kyoto 6158245 (JP); Oda, Masaya, Kyoto-shi, Kyoto 6158245 (JP); Hitora, Toshimi, Kyoto-shi, Kyoto 6158245 (JP)
(74) Representative: Gulde & Partner

(57) **Abstract**

Provided is a film forming apparatus which is excellent in the film formation rate and is useful for performing mist CVD. A film forming apparatus includes an atomization/droplet-formation unit for turning a raw-material solution into a mist or droplets a raw-material solution, a carrying unit for carrying the mist or droplets generated in the atomization/droplet-formation unit onto a base using a carrier gas, and a film forming unit for treating the mist or droplets with heat to form a film on the base. The film forming unit is cylindrical or almost cylindrical and has an inlet for introducing the mist or droplets in a side surface thereof so that the mist or droplets is swirled to generate a swirling flow. And the film forming unit has an exhaust outlet in a top surface thereof.

## Description

### Technical Field

The present invention relates to a novel film forming apparatus and a method which are useful for performing a mist chemical vapor deposition.

### Background Art

There have developed high-vacuum film forming apparatuses which can realize a non-equilibrium state using a pulsed laser deposition (PLD), a molecular beam epitaxy (MBE), a sputtering, or the like. Such apparatuses have made it possible to form oxide semiconductors, which have been conventionally unable to form using traditional melt methods or the like. Among them, it has been developed the mist chemical vapor deposition (hereafter may be referred to as "mist CVD"), which grows a crystal on a substrate using an atomized raw material (a mist). And mist CVD has made it possible to form a corundum-structured gallium oxide (α-Ga₂O₃). As a large-bandgap semiconductor, α-Ga₂O₃ is expected to be applied to next-generation switching devices which can realize a high voltage, a low loss, and a high heat resistance.

With regard to mist CVD, Japanese Unexamined Patent Application Publication No. 1-257337 discloses a tubular-furnace mist CVD apparatus. Japanese Unexamined Patent Application Publication No. 2005-307238 discloses a fine-channel mist CVD apparatus. Japanese Unexamined Patent Application Publication No. 2012-46772 discloses a liner-source mist CVD apparatus. Japanese Patent No. 5397794 discloses a tubular-furnace mist CVD apparatus. This mist CVD apparatus differs from that of Japanese Unexamined Patent Application Publication No. 1-257337 in that a carrier gas is introduced into a mist generator. Japanese Unexamined Patent Application Publication No. 2014-63973 discloses a mist CVD apparatus in which a substrate is placed above a mist generator and a susceptor is a rotating stage disposed on a hot plate.

### Summary of the Invention

Unlike other methods, mist CVD does not require high temperature and allows for formation of a metastable-phase crystal structure like the corundum structure of α-gallium oxide. On the other hand, mist CVD involves growing a crystal without mist droplets directly contacting the film by covering the substrate surface with a mist volatilization layer due to the Leidenfrost effect described in B. S. Gottfried., et al., "Film Boiling of Spheroidal Droplets. Leidenfrost Phenomenon", Ind. Eng. Chem. Fundamen., 1966, 5 (4), pp 561 to 568. Such crystal growth is not easy to control, and a uniform crystal film is difficult to obtain. Further, for mist CVD, there are variations among the mist particles, and the mist sinks down in the supply pipe before reaching the substrate. These problems have led to low film formation rates or the like.

An object of the present invention is to provide a film forming apparatus and method which are excellent in the film formation rate and are useful for performing mist CVD.

The inventors intensively conducted research to accomplish the above object and then succeeded in forming a mist CVD apparatus in which a film forming unit includes means configured to swirl a mist or droplets to generate a swirling flow. When the inventors formed a film using this mist CVD apparatus and using mist CVD, they obtained surprising findings including the following: the film formation rate was excellent; the film thickness was distributed uniformly; and large-area films could be formed. The inventors then confirmed that this apparatus could solve all the above problems with the traditional art.

After obtaining the findings, the inventors further conducted research and then completed the present invention.

Aspects of the present invention are follows:
[.1] A film forming apparatus includes an atomization/droplet-formation unit for turning a raw material solution into a mist or droplets, a carrying unit for carrying the mist or droplets generated in the atomization/droplet-formation unit onto a base using a carrier gas, and a film forming unit for treating the mist or droplets with heat to form a film on the base. The film forming unit includes means configured to swirl the mist or droplets for generating a swirling flow.
[.2] In the film forming apparatus of the above [.1], the swirling flow preferably flows inwardly.
[.3] In the film forming apparatus of the above [.1] or [.2], the film forming unit is preferably cylindrical or almost cylindrical and has, in a side surface thereof, an inlet for introducing the mist or droplets.
[.4] In the film forming apparatus of the above [.3], the film forming unit has an outlet for exhausting the mist or droplets in a portion more remote from the base than the inlet thereof.
[.5] The film forming apparatus of any one of the above [.1] to[.4] preferably further includes an exhaust fan.
[.6] In the film forming apparatus of any one of the above [.1] to [.5], the film forming unit preferably includes a hot plate.
[.7] In the film forming apparatus of any one of the above [.1] to [.6], the atomization/droplet-formation unit preferably includes an ultrasonic transducer.
[.8] A method for forming a film, includes: turning a raw-material solution into a mist or droplets; carrying the mist or droplets onto a base placed in a film forming chamber using a carrier gas; and after the carrying step, forming a film by causing the mist or droplets to thermally react on the base. The film forming step includes swirling the mist or droplets for generating a swirling flow in the film forming chamber.
[.9] In the method for a film of the above [.8], the swirling flow preferably flows inwardly.
[.10] In the method for forming a film of the above [.8] or [.9], the film forming chamber is preferably cylindrical or almost cylindrical and has, in a side surface thereof, an inlet for introducing the mist or droplets.
[.11] In the method for forming a film of the above [.10], the film forming chamber has an outlet for exhausting the mist or droplets in a portion more remote from the base than the inlet of the film forming unit.
[.12] The method for forming a film of the above [.11] preferably further includes exhausting using an exhaust fan.
[.13] In the method for forming a film of the above [.8] to [.12], the raw-material solution is preferably turned into the mist or droplets using ultrasonic vibration.

The film forming apparatus and method of the present invention are useful for performing mist CVD and are excellent in the film formation rate.

### Brief Description of the Drawings

Fig. 1 is a diagram showing a schematic configuration of a film forming apparatus of the present invention;
Fig. 2 is a diagram showing one embodiment of an atomization/droplet-formation unit used in the present invention;
Fig. 3 is a diagram showing one embodiment of an ultrasonic transducer in Fig. 2;
Fig. 4 is a diagram showing one embodiment of a film forming unit used in the present invention;
Fig. 5 is a diagram showing film thickness measurement positions in an Example;
Fig. 6 is a diagram showing a schematic configuration of a film forming apparatus used in Comparative Example;
Fig. 7 is a diagram showing film thickness measurement positions in Comparative Example;
Figs. 8A and 8B are schematic views showing the flow of the mist or droplets on a substrate in a film forming chamber of Fig. 4, in which Fig. 8A is a schematic sectional view of the cylindrical film forming chamber seen from above, and Fig. 8B is a schematic sectional view of the cylindrical film forming chamber seen from a side; and
Fig. 9 is a diagram showing XRD measurement results of another Example.

### Description of Embodiments

A film forming apparatus of the present invention includes an atomization/ droplet-formation unit for turning a raw material solution into a mist or droplets, a carrying unit for carrying the mist or droplets generated in the atomization/droplet-formation unit onto a base using a carrier gas, and a film forming unit for treating the mist or droplets with heat to form a film on the base. The film forming unit includes means configured to swirl the mist or droplets for generating a swirling flow.

Now, a film forming apparatus of the present invention will be described with reference to the accompanying drawings. However, the present invention is not limited to the drawings.

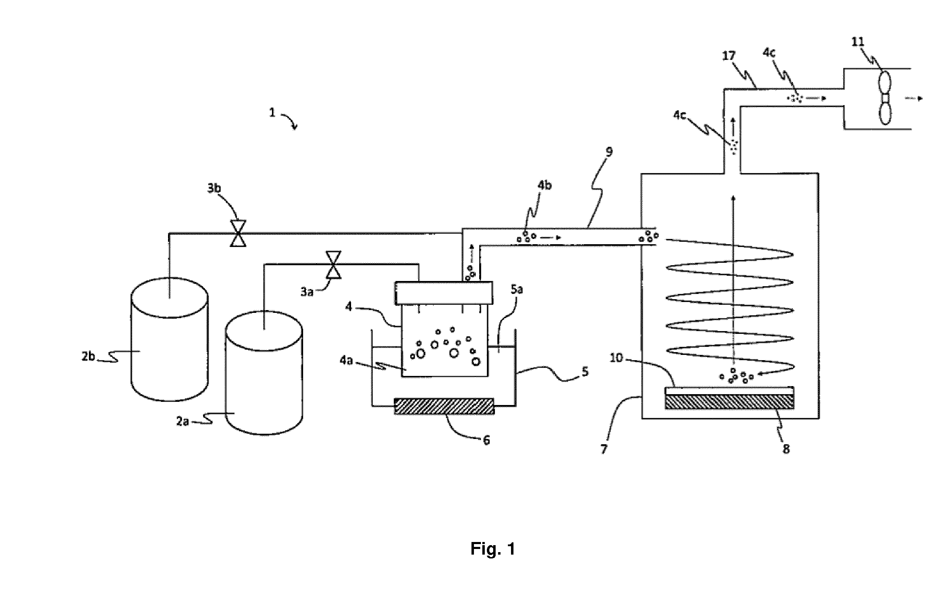

Fig. 1 shows an example of the film forming apparatus of the present invention. A film forming apparatus 1 includes a carrier gas source 2a for supplying a carrier gas, a flow rate control valve 3a for controlling the flow rate of the carrier gas sent from the carrier gas source 2a, a dilution carrier gas source 2b for supplying a dilution carrier gas, a flow rate control valve 3b for adjusting the flow rate of the dilution carrier gas sent from the dilution carrier gas source 2b, a mist source 4 containing a raw-material solution 4a, a container 5 containing water 5a, an ultrasonic transducer 6 mounted on the bottom of the container 5, a film forming chamber 7, a supply pipe 9 connecting the mist source 4 to the film forming chamber 7, a hot plate 8 disposed in the film forming chamber 7, an exhaust pipe 17, and an exhaust fan 11. A substrate 10 is placed on the hot plate 8.

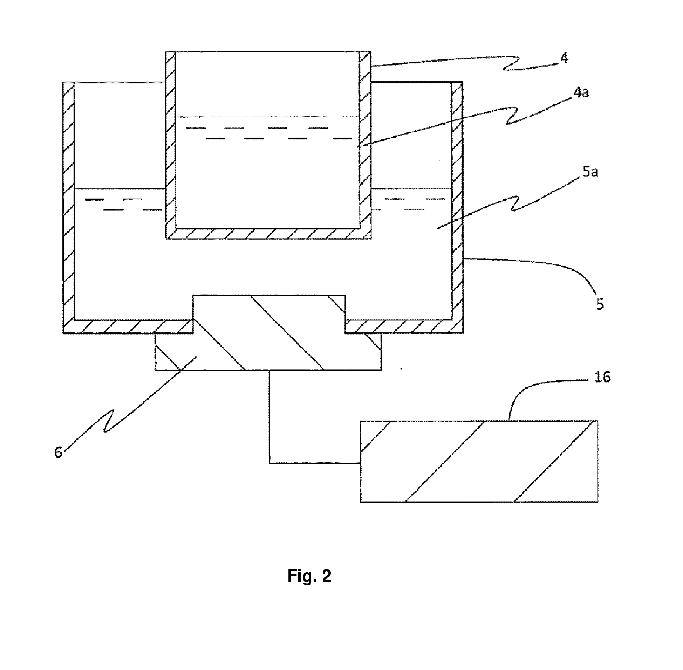

The film forming apparatus 1 of the present invention includes an atomization/droplet-formation unit for turning a raw-material solution into the mist or droplets. Fig. 2 shows one embodiment of the atomization/droplet-formation unit. The mist source 4 is a container containing the raw-material solution 4a. The mist source 4 is supported in the container 5, which contains the water 5a, using a supporter (not shown). The ultrasonic transducer 6 is mounted on the bottom of the container 5 and connected to an oscillator 16. By operating the oscillator 16, the ultrasonic transducer 6 vibrates to generate ultrasound, which then propagates through the water 5a into the mist source 4, so that the raw-material solution 4a is turned into the mist or droplets.

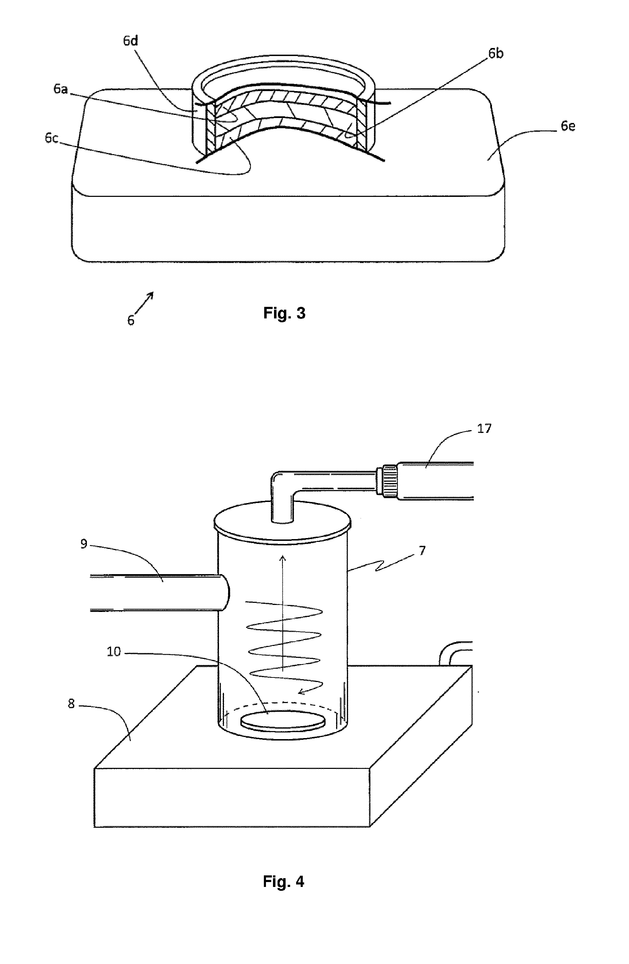

Fig. 3 shows one embodiment of the ultrasonic transducer 6 shown in Fig. 2. As shown in Fig. 3, in the ultrasonic transducer 6, a disc-shaped piezoelectric element 6b is disposed in a cylindrical elastic object 6d on a supporter 6e, and electrodes 6a and 6c are disposed on both surfaces of the piezoelectric element 6b. By connecting the oscillator to the electrodes and changing the oscillation frequency, there is generated ultrasound having a resonant frequency in the thickness direction of the piezoelectric vibrator and a resonant frequency in the radial direction thereof.

As described above, the atomization/droplet-formation unit prepares a raw-material solution and turns the raw-material solution into the mist or droplets to generate the mist or droplets. The atomization/droplet-formation unit is not particularly limited as long as it can turn the raw-material solution into the mist or droplets, and may be known atomization/droplet-formation means. In the present invention, the atomization/droplet-formation unit is preferably atomization means or droplet-formation means which uses ultrasonic vibration.

A carrying unit carries the mist or droplets onto the base using the carrier gas and optionally a supply pipe or the like. The type of the carrier gas is not particularly limited as long as the objects of the present invention are not impaired. Preferred examples include oxygen, ozone, inert gases such as nitrogen and argon, and reducing gases such as hydrogen gas and forming gas. The number of carrier gases may be one, but may be two or more. For example, there may be used, as a second carrier gas, a gas obtained by diluting the same gas as a first carrier gas using another gas (e.g., by diluting gas 10 times). The number of locations for supplying the carrier gas is not limited to one and may be two or more. The flow rate of the carrier gas is not particularly limited. However, when forming a film on a 30-mm square substrate, for example, the flow rate is preferably 0.01 to 20L/min, more preferably 1 to 10L/min.

The film forming unit treats the mist or droplets with heat to cause a thermal reaction, thereby forming a film on part or all of the base surface. The thermal reaction is not particularly limited as long as the mist or droplets reacts with heat applied. The reaction conditions or the like are also not particularly limited as long as the objects of the present invention are not impaired. However, the heating temperature is typically 120 to 600°C, preferably 120 to 350°C, more preferably 130 to 300°C. Further, the thermal reaction may be caused under any of vacuum, a non-oxygen atmosphere, a reducing gas atmosphere, and an oxygen atmosphere as long as the objects of the present invention are not impaired. Furthermore, the thermal reaction may be caused under any of an atmospheric pressure, an elevated pressure, and a reduced pressure, but is preferably caused under the atmospheric pressure.

Fig. 4 shows one embodiment of the film forming unit. The film forming chamber 7 of Fig. 4 is cylindrical and is disposed on the hot plate 8. The film forming chamber 7 is connected to the mist source 4 via the supply pipe 9. Mist or droplets 4b generated in the mist source 4 is carried through the supply pipe 9 into the film forming chamber 7 by the carrier gas and then thermally reacts on the substrate 10 placed on the hot plate. The film forming chamber 7 has an outlet for exhausting the mist or droplets in the center of the ceiling surface (upper surface). The outlet is disposed in a portion more remote from the substrate than an inlet. The film forming chamber 7 is connected to an exhaust pipe 17 at the outlet so that the resulting mist or droplets or exhaust gas 4c is exhausted through the exhaust pipe 17. In the present invention, the film forming apparatus 1 may further include trapping means configured to trap the resulting mist or droplets, or exhaust gas. After the mist or droplets 4b is carried into the film forming chamber 7, the mist or droplets flows toward the substrate, as shown by an arrow in Fig. 4. At this time, an inward swirling flow occurs. The swirling mist or droplets 4b then thermally reacts on the substrate. The resulting mist or droplets or exhaust gas flows toward the outlet, as shown by an arrow in Fig. 4, and then flows into the exhaust pipe 17.

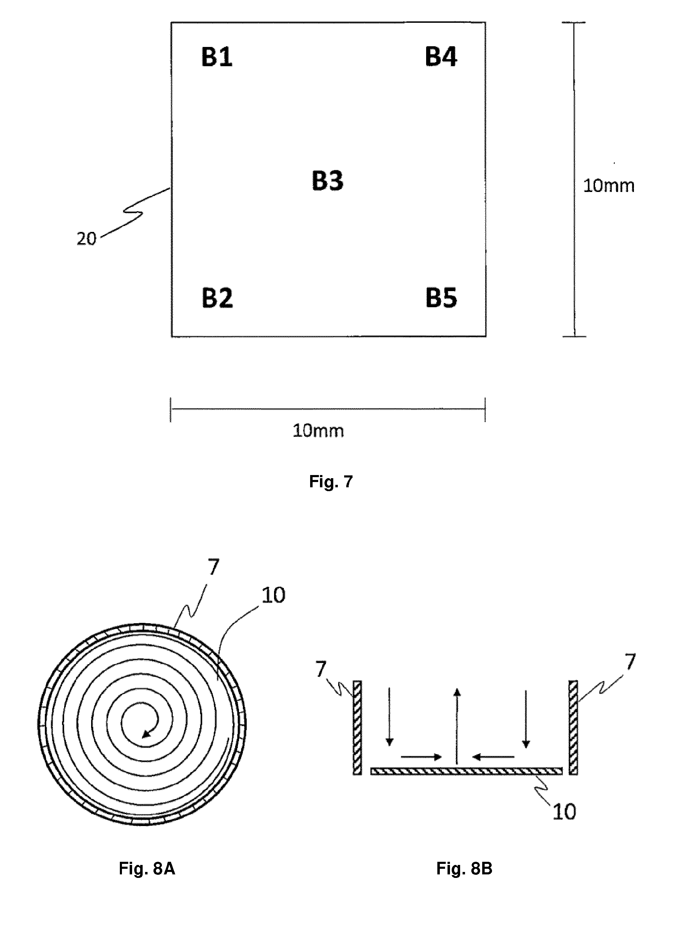

The swirling flow may flow in any of the inward direction and outward direction. In the present invention, it preferably flows in the inward direction. Figs. 8A and 8B are schematic diagrams showing the flow of the mist or droplets on the substrate in the film forming chamber of Fig. 4. Fig. 8A is a sectional view of the cylindrical film forming chamber 7 seen from above. The substrate 10 is placed in the film forming chamber 7, and the flow of the mist or droplets is shown by an arrow. In the film forming chamber of Fig. 4, the mist or droplets flows toward the center of the substrate while swirling inwardly, that is, there occurs a swirling flow which flows in the direction of an arrow in Fig. 8A. Fig. 8B is a schematic sectional view of the film forming chamber 7 seen from a side, and the substrate 10 is placed in the film forming chamber 7. As shown by arrows in Fig. 8B, the mist or droplets flows from the outside to the inside. When the mist or droplets reaches near the center of the substrate, the mist or droplets upwardly flows toward the outlet disposed above. Note that in the present invention, the base may be in face-down orientation, for example, by placing it on the top surface of the film forming chamber, or may be in face-up orientation by placing it on the bottom surface thereof, as shown in Fig. 4. The means for generating the swirling flow is not particularly limited as long as the objects of the present invention are not impaired, and may be known means. For example, the following swirling flow generation means may be employed: a cylindrical film forming chamber is used; a base is placed on the bottom surface or top surface of the chamber; the mist or droplets is introduced from the side of the chamber; and an outlet is formed in a surface opposite to the surface (preferably, the position) having the base placed thereon. The mist or droplets is preferably introduced into the film forming chamber in such a manner that the mist or droplets moves along the inner surface of the chamber. For this reason, the inlet is preferably oriented substantially to the direction of a tangent to the inner surface of the film forming chamber. However, even if the mist or droplets is introduced into the film forming chamber toward the center in the radial direction of the film forming chamber, if there is used known means such as adjusting of the flow rate of the carrier gas as appropriate, a swirling flow can be generated. Accordingly, the direction of introduction of the mist or droplets is not particularly limited. The flow rate of the swirling flow is not particularly limited as long as the objects of the present invention are not impaired, but is preferably 10 to 100cm/s, more preferably 20 to 70cm/s.

Referring now to Fig. 1, a film forming process using the film forming apparatus 1 of the present invention will be described.

First, the raw-material solution 4a is charged into the mist source 4, the substrate 10 is placed on the hot plate 8, and the hot plate 8 is operated. Then, the flow rate control valves 3(3a, 3b) are opened to feed the carrier gas and dilution carrier gas from the carrier-gas sources 2 (2a, 2b) into the film forming chamber 7. After sufficiently substituting the carrier gas and dilution carrier gas for the atmosphere in the film forming chamber 7, the respective flow rates of the carrier gas and dilution carrier gas are adjusted. Subsequently, the ultrasonic transducer 6 is vibrated so that the vibration propagates through the water 5a into the raw-material solution 4a. Thus, the raw-material solution 4a is turned into the mist or droplets 4b. The mist or droplets 4b is then carried into the film forming chamber 7 by the carrier gas. The film forming chamber 7 has the outlet connected to the exhaust pipe 17 in the center of the top surface thereof. The exhaust pipe 17 is connected to the exhaust fan 11, which draws an exhaust gas or the like from the outlet of the film forming chamber 7. The cylindrical film forming chamber 7 has the inlet for introducing the mist or droplets in a side surface thereof. The mist or droplets introduced into the film forming chamber 7 is swirled to generate an inwardly swirling flow. The swirling mist or droplets then thermally reacts with heat generated by the hot plate 8 in the film forming chamber 7, thereby forming a film on the substrate 10.

The shape of the film forming chamber is not particularly limited as long as the objects of the present invention are not impaired, but is preferably tubular. The shape of the film forming chamber may be cylindrical, almost cylindrical, prismatic (e.g., cubic, rectangular parallelepiped-shaped, pentagonal prism-shaped, hexagonal prism-shaped, octagonal prism-shaped, or the like), or almost prismatic, but is preferably cylindrical or almost cylindrical in the present invention.

The base may be rotated during formation of a film, and the rotation direction is preferably opposite to the direction of the swirling flow.

### Raw-Material Solution

The raw-material solution is not particularly limited as long as it contains a raw material which can be turned into the mist or droplets. Such a raw material may be inorganic or organic. In the present invention, the raw material is preferably a metal or metal compound, more preferably contains one or two metals selected from gallium, iron, indium, aluminum, vanadium, titanium, chromium, rhodium, nickel, and cobalt.

The raw-material solution is not particularly limited as long as the metal can be turned into the mist or droplets. Preferably, the raw-material solution is one obtained by dissolving or dispersing the metal taking the form of a complex or salt in an organic solvent or water. Examples of the complex form include acetylacetonate complex, carbonyl complex, ammine complex, and hydrido complex. Examples of the salt form include metal chloride salts, metal bromide salts, and metal iodide salts.

The raw-material solution may contain an additive such as halide acid or oxidant. Examples of the halide acid include hydrobromic acid, hydrochloric acid, and hydroiodic acid. Among others, hydrobromic acid and hydroiodic acid are preferred. Examples of the oxidant include peroxides such as hydrogen peroxide (H₂O₂), sodium peroxide (Na₂O₂), barium peroxide (BaO₂), and benzoyl peroxide(CeH₅CO)₂O₂ and organic peroxides such as hypochlorous acid (HClO), perchloric acid, nitric acid, ozone water, peracetic acid, and nitrobenzene.

The raw-material solution may contain a dopant. The type of the dopant is not particularly limited as long as the objects of the present invention are not impaired. Examples of the dopant include n-type or p-type dopants, including tin, germanium, silicon, titanium, zirconium, vanadium, and niobium. The concentration of the dopant may be about 1×10¹⁶/cm³ to 1×10²²/cm³, or may be as low as e.g., about 1×10¹⁷/cm³ or less. In the present invention, the raw-material solution may also contain a dopant at a high concentration of about 1×10²⁰/cm³ or more.

### Base

The base is not particularly limited as long as it can support the film. The material of the base also is not particularly limited as long as the objects of the present invention are not impaired, and may be known bases, organic compounds, or inorganic compounds. The base may be in any shape, including plates such as a flat plate and disc, a fiber, a bar, a cylinder, a prism, a tube, a spiral, a sphere, and a ring. In the present invention, the base is preferably in the shape of a substrate. The thickness of the substrate is not particularly limited in the present invention, but is preferably 10 to 2000 µm, more preferably 50 to 800 µm.

Use of the film forming apparatus and method of the present invention in the above manner allows for film formation at high rates even when using mist CVD, as well as allows for uniform distribution of film thicknesses and formation of large-area films.

### Examples

Now, Examples of the present invention will be described. However, the present invention is not limited thereto.

### Example 1

### 1. Film Forming Apparatus

First, referring back to Fig. 1, the film forming apparatus 1 used in the present Example will be described again. The film forming apparatus 1 includes the carrier gas source 2a for supplying a carrier gas, the flow rate control valve 3a for controlling the flow rate of the carrier gas sent from the carrier gas source 2a, the dilution carrier gas source 2b for supplying a dilution carrier gas, the flow rate control valve 3b for controlling the flow rate of the dilution carrier gas sent from the dilution carrier gas source 2b, the mist source 4 containing the raw-material solution 4a, the container 5 containing the water 5a, the ultrasonic transducer 6 mounted on the bottom of the container 5, the film forming chamber 7, the quartz supply pipe 9 connecting the mist source 4a to the film forming chamber 7, the hot plate 8 mounted in the film forming chamber 7, the exhaust pipe 17, and the exhaust fan 11. The substrate 10 is placed on the hot plate 8.

### 2. Preparation of Raw-Material Solution

An aqueous solution of 0.1 mol/L of gallium bromide was prepared, and 10% by volume of a 48% hydrobromic acid solution was added to give a raw-material solution.

### 3. Preparation for Film Formation

The raw-material solution 4a obtained in the above 2. was charged into the mist source 4. Then, a 4-inch c-plane sapphire substrate serving as the substrate 10 was placed on the hot plate 8, which was then operated to increase the temperature in the film forming chamber 7 to 500°C. Then, the flow rate control valves 3 (3a, 3b) were opened to feed the carrier gas and dilution carrier gas from the carrier-gas sources 2 (2a, 2b) into the film forming chamber 7. After sufficiently substituting the carrier gas and dilution carrier gas for the atmosphere in the film forming chamber 7, the flow rates of the carrier gas and dilution carrier gas were adjusted to 5L/min and 0.5L/min, respectively. Oxygen was used as the carrier gas.

### 4. Formation of Monolayer Film

Subsequently, the ultrasonic transducer 6 was vibrated at 2.4 MHz so that the vibration propagated through the water 5a into the raw-material solution 4a. Thus, the raw-material solution 4a was atomized into the mist 4b. The mist 4b was carried into the film forming chamber 7 by the carrier gas and then swirled therein, thereby generating an inwardly swirling flow as shown in Fig. 8. The swirling mist then made a reaction under atmospheric pressure and at 560°C in the film forming chamber 7, thereby forming a thin film on the substrate 10. The flow rate of the mist was 45.6cm/s, and the film formation time was 30 min.

### 5. Evaluation

The phase of the α-Ga₂O₃ thin film obtained in the above 4. was identified. The identification was made by 2θ/ω) scanning the thin film at angles of 15 to 95 degrees using an XRD diffractometer for thin films. Then, a measurement was made using CuKα rays. As a result, the thin film was found to be α-Ga₂O₃.

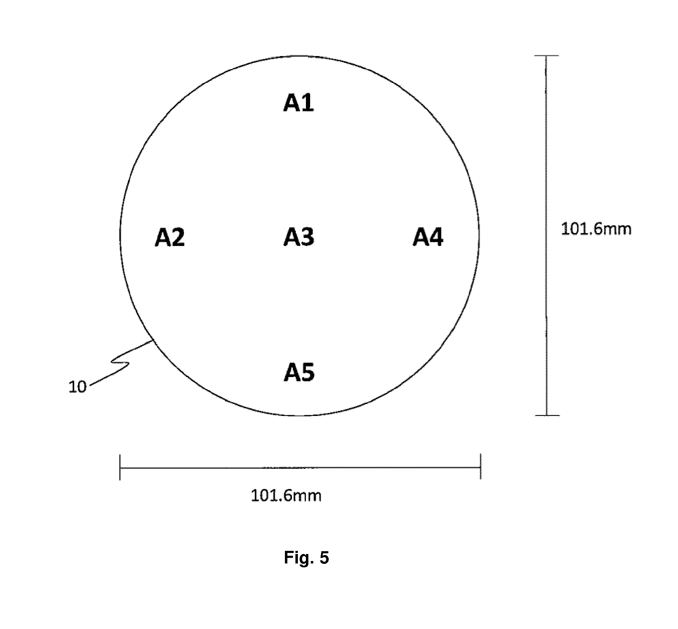

The thicknesses of measurement positions A1, A2, A3, A4, and A5 of the thin film on the substrate 10 shown in Fig. 5 were measured using a step gauge, and the thicknesses measured were averaged to obtain an average thickness of 3,960 nm. The average thickness was divided by the film formation time to obtain a film formation rate of 132 nm/min.

### Comparative Example

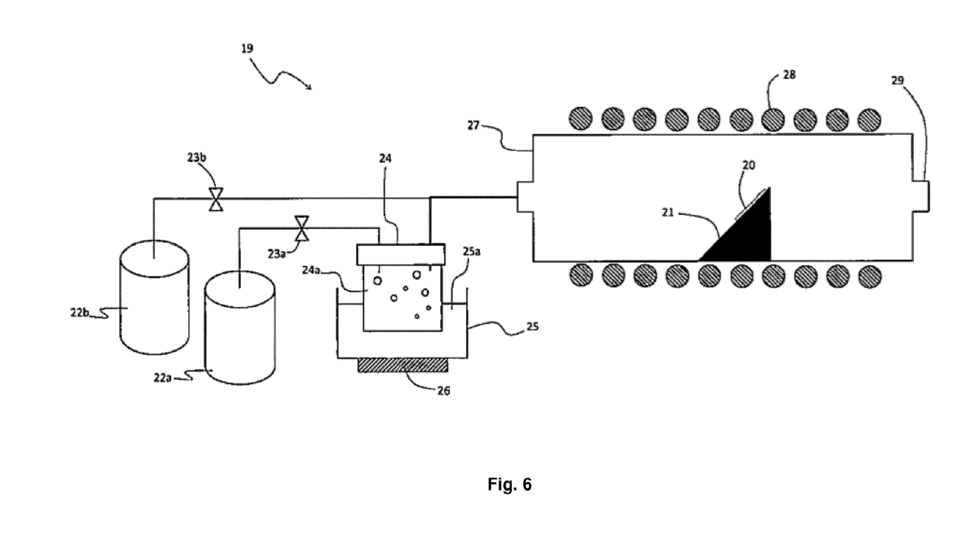

Referring now to Fig. 6, a film forming apparatus 19 used in Comparative Example will be described. The mist CVD apparatus 19 includes a susceptor 21 having a substrate 20 placed thereon, carrier gas supply means 22a for supplying a carrier gas, a flow rate control valve 23a for controlling the flow rate of the carrier gas sent from the carrier gas supply means 22a, dilution carrier gas supply means 22b for supplying a dilution carrier gas, a flow rate control valve 23b for controlling the flow rate of the dilution carrier gas sent from the dilution carrier gas supply means 22b, a mist source 24 containing a raw-material solution 24a, a container 25 containing water 25a, an ultrasonic transducer 26 mounted on the bottom of the container 25, a supply pipe 27 made of a 40 mm-inner diameter quartz tube, a heater 28 disposed around the supply pipe 27, and an outlet 29. The susceptor 21 is formed of quartz, and the surface having the substrate 20 placed thereon is inclined from the horizontal plane by 45 degrees. By forming both the supply pipe 27 and susceptor 21 serving as a film forming chamber from quartz, entry of apparatus-derived impurities into a film formed on the substrate 20 is reduced.

A film was formed as in Example 1 except that the film forming apparatus shown in Fig. 6 was used and a 10 mm square c-plane sapphire substrate was used as the substrate 20. The phase of the obtained thin film was identified using an XRD diffractometer for thin films, as in Example 1. Thus, the obtained thin film was found to be α-Ga₂O₃. Further, the thicknesses of the thin film were measured as in the Example. Specifically, the thicknesses of measurement positions B1, B2, B3, B4, and B5 of the thin film on the substrate 20 shown in Fig. 7 were measured. The measurement results are shown as Comparative Example in Table 1.

### Example 2

A film was formed as in Example 1 except that a 10-mm square c-plane sapphire was used as the substrate 10. The phase of the obtained thin film was identified using an XRD diffractometer for thin films, as in Comparative Example. Thus, the obtained thin film was found to be α-Ga₂O₃. Further, the thicknesses thereof were measured as in Comparative Example. Specifically, the thicknesses of measurement positions B1, B2, B3, B4, and B5 of the thin film were measured as in Comparative Example except that the substrate 10 was used in place of the substrate 20. The measurement results are shown as Example 2 in Table 1.

**[Table 1]**

| Measuement position | Film thickness (nm) | |
|---|---|---|
| | Example 2 (substrate: 10 mm square) | Comparative Example (substrate: 10 mm square) |
| B1 | 3,902 | 674 |
| B2 | 4,311 | 499 |
| B3 | 4,010 | 593 |
| B4 | 3,869 | 809 |
| B5 | 3,698 | 552 |

The average thickness, film formation rate, variation coefficient and in-plane uniformity of each Example were obtained from the results in Table 1. The results are shown in Table 2. The average thickness is the average of the film thicknesses of the measurement positions; the film formation rate is a value obtained by dividing the average film thickness by the film formation time (min); the variation coefficient is a coefficient obtained by dividing the standard deviation of the film thicknesses by the average thickness; and the in-plane uniformity indicates the variation range by expressing the difference between the average thickness and the largest or smallest thickness in percentage.

**[Table 2]**

| | Example 2 (substrate: 10 mm square) | Comparative Example (substrate: 10 mm square) |
|---|---|---|
| Average film thickness | 3,958 nm | 625 nm |
| Film formation rate | 132 nm/min | 21 nm/min |
| Variation coefficient | 0.05 | 0.17 |
| In-plane uniformity | -7% to +9% | -20% to +29% |

As are apparent in Tables 1 and 2, the film formation rate of Example 2 is incomparably higher than that of Comparative Example, and there are also clear differences in film forming quality such as in-plane uniformity between the Examples. As seen above, the film forming apparatus and method of the present invention are excellent in the film formation rate, film thickness uniformity, and the like, compared to the traditional mist CVD apparatus.

### Example 3

An aqueous solution was prepared such that the molar ratio between gallium acetylacetonate and aluminum acetylacetonate was 1:6 and the volume percentage of hydrochloric acid was 2% to give a raw-material solution.

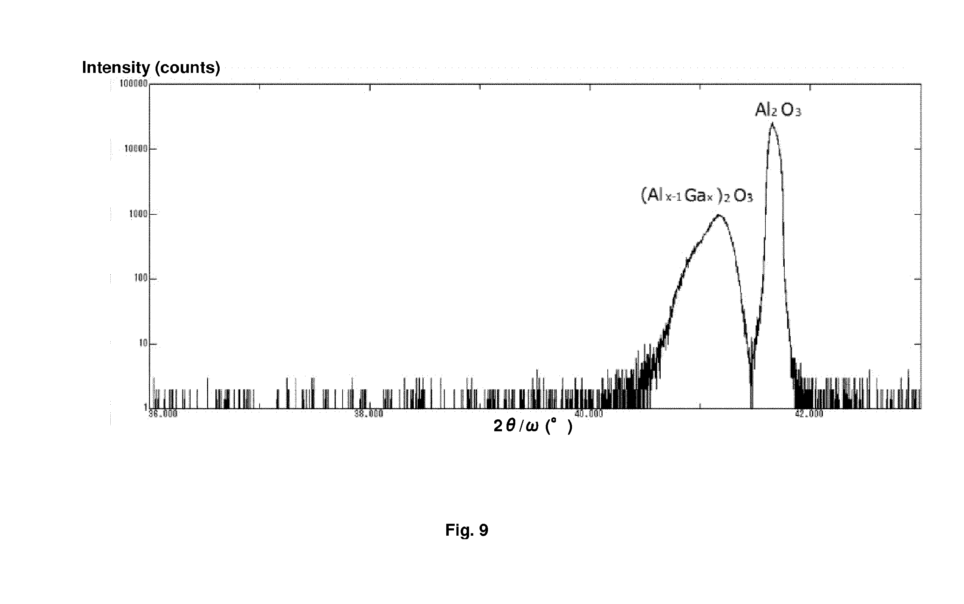

A film was formed as in Example 1 except that the raw-material solution obtained was used; the film forming temperature was 600°C; the flow rate of the carrier gas was 8 LPM; and the film formation time was 3 h. The flow rate of the mist was 73.0cm/s. Subsequently, the aluminum content of the film obtained was measured using X rays. The XRD measurement results are shown in Fig. 9. The XRD measurement results indicate that the film obtained was a corundum-structured, 62.8%-aluminum-containing, AlGaO-based semiconductor film, which has been deemed difficult to form. Further, the thickness of the corundum-structured AlGaO-based semiconductor film was measured and found to be 720 nm.

Although the traditional art allows for formation of a corundum-structured AlGaO-based semiconductor film, it does not allow for formation of such a film which is 50 nm or more thick. The present invention, on the other hand, allows for formation of a corundum-structured AlGaO-based semiconductor film which is as thick as 700 nm or more. This Example also reveals that the film forming apparatus of the present invention is excellent in the suitability for mist CVD, as well as incomparably excellent in the film formation rate.

The film forming apparatus and method of the present invention are applicable to all film forming fields and industrially useful. In particular, the film forming apparatus and method of the present invention can be suitably used in forming a film by mist CVD.

## Claims

1. A film forming apparatus comprising:
an atomization/droplet-formation unit for turning a raw-material solution into a mist or droplets;
a carrying unit for carrying the mist or droplets generated in the atomization/droplet-formation unit onto a base using a carrier gas; and
a film forming unit for treating the mist or droplets with heat to form a film on the base, wherein
the film forming unit comprises means configured to swirl the mist or droplets for generating a swirling flow.

2. The film forming apparatus of claim 1, wherein the swirling flow flows inwardly.

3. The film forming apparatus of claim 1 or 2,
wherein the film forming unit is cylindrical or almost cylindrical and has, in a side surface thereof, an inlet for introducing the mist or droplets.

4. The film forming apparatus of claim 3, wherein the film forming unit has an outlet for exhausting the mist or droplets is formed in a portion more remote from the base than the inlet thereof.

5. The film forming apparatus of any one of claims 1 to 4, further comprising an exhaust fan.

6. The film forming apparatus of any one of claims 1 to 5, wherein the film forming unit has a hot plate.

7. The film forming apparatus of any one of claims 1 to 6, wherein the atomization/droplet-formation unit comprises an ultrasonic transducer.

8. A method for forming a film, comprising:
Turning a raw-material solution into a mist or droplets;
carrying the mist or droplets onto a base placed in a film forming chamber using a carrier gas; and
after the carrying step, forming a film by causing the mist or droplets to thermally react on the base, wherein the film forming step comprises swirling the mist or droplets for generating a swirling flow in the film forming chamber.

9. The method for a film of claim 8, wherein the swirling flow flows inwardly.

10. The method for forming a film of claim 8 or 9,
wherein the film forming chamber is cylindrical or almost cylindrical and has, in a surface thereof, an inlet for introducing the mist or droplets.

11. The method for forming a film of claim 10, wherein the film forming chamber has an outlet for exhausting the mist or droplets is formed in a portion more remote from the base than the inlet of the film forming chamber.

12. The method for forming a film of claim 11, wherein further comprising exhausting using an exhaust fan.

13. The method for forming a film of any one of claims 8 to 12, wherein the raw-material solution is turned into the mist or droplets using ultrasonic vibration.
